# FASCICULE DE BREVET EUROPEEN

(11) **EP 3 226 289 B1**
(45) Date de publication et mention de la délivrance du brevet: **14.07.2021**
(21) Numéro de dépôt: 17161074.4
(22) Date de dépôt: 15.03.2017
(51) Int. Cl.: H01L 23/433, H01L 23/367

(54) **DISPOSITIF ÉLECTRONIQUE POURVU D'UN ORGANE DE DISSIPATION DE LA CHALEUR**
ELEKTRONISCHE VORRICHTUNG MIT EINEM WÄRMEABLEITUNGSORGAN
ELECTRONICAL DEVICE WITH A THERMAL DISSIPATION ELEMENT

(30) Priorité: 30.03.2016 FR 1652720
(43) Date de publication de la demande: 04.10.2017
(73) Titulaire: Commissariat à l'énergie atomique et aux énergies alternatives, 75015 Paris (FR); STMicroelectronics (Crolles 2) SAS, 38920 Crolles (FR); STMICROELECTRONICS SA, 92120 Montrouge (FR)
(72) Inventeur: PRIETO HERRERA, Rafael, 38000 GRENOBLE (FR); COLONNA, Jean-Philippe, 38700 CORENC (FR); COUDRAIN, Perceval, 38000 GRENOBLE (FR)
(74) Mandataire: Casalonga

(56) Documents cités:
- DE-A1-102005 023 129
- JP-A- H1 168 360
- JP-A- H08 241 940
- US-A1- 2006 087 015

## Description

La présente invention concerne le domaine des dispositifs électroniques qui comprennent des puces de circuits intégrés.

Dans le domaine des dispositifs qui comprennent une plaquette de support, une puce de circuits intégrés montée sur la plaquette de support et un bloc d'encapsulation de la puce, généralement appelés des boîtiers électroniques, il existe une difficulté d'évacuation de la chaleur produite par les puces.

Pour tenter de résoudre cette difficulté, plusieurs solutions sont connues.

Une solution consiste à coller une plaque extérieure métallique sur la puce, cette plaque métallique étant éventuellement pourvue d'ailettes espacées, de façon à former un radiateur de dissipation de la chaleur produite par la puce.

Une autre solution consiste à placer la puce contre la coque d'un appareil, par exemple d'un téléphone portable, cette coque étant utilisée pour diffuser la chaleur produite par la puce.

Par ailleurs, le brevet US 2006/0087015-A1 décrit un dispositif électronique qui comprend un support, une puce électronique fixée sur une face avant du support et une feuille flexible qui comprend des portions successives reliées par un pli. L'une des portions de la feuille flexible est fixée sur une face avant de la puce tandis que, lors du moulage d'un bloc d'encapsulation, une autre portion de la feuille flexible est simplement maintenue en appui contre une face de la cavité du moule opposée à la face avant de la puce ou contre la face avant du support sous l'effet de l'élasticité de la feuille flexible. Le brevet DE 10 2005 023 129-A1, le brevet JP H08 241940-A et le brevet JP H11 68360-A décrivent des dispositifs électroniques équivalents au dispositif décrit dans le brevet US 2006/0087015-A1.

Selon un mode de réalisation, il est proposé un dispositif électronique qui comprend un support, un composant susceptible de produire de la chaleur, en particulier une puce de circuits intégrés, présentant une face arrière montée au-dessus d'une face avant du support et une face avant opposée à sa face arrière, et un bloc d'encapsulation au moins partiel de la puce au-dessus de la face avant de la plaquette de support.

Le dispositif comprend en outre au moins un organe de dissipation de la chaleur comprenant une feuille flexible présentant une pluralité de portions successives, dans laquelle au moins deux portions sont jointes par un pli et sont au moins en partie en vis-à-vis l'une de l'autre, une première portion de ladite feuille flexible étant fixée au moins localement sur la face avant dudit composant et l'extrémité d'une deuxième portion étant fixée au moins localement sur la première portion par l'intermédiaire d'une colle thermique ou d'une pâte thermique ou par soudage ou par adhésion moléculaire par compression.

Ainsi, en étant fixée en deux endroits espacés, la feuille flexible garde sa forme reste correctement maintenue par rapport au composant et au support.

Ladite feuille flexible peut comprendre au moins une partie principale comprenant au moins ladite première portion et au moins une partie secondaire comprenant au moins ladite deuxième portion.

Ladite partie secondaire peut comprendre au moins une portion rabattue au-dessus de ladite partie principale.

Ladite feuille flexible peut être au moins en partie noyée dans le bloc d'encapsulation.

Ladite feuille flexible peut présenter des perforations.

Ladite feuille flexible peut être en cuivre ou en graphite.

Il est également proposé un système comprenant le dispositif électronique, le support pouvant être monté sur une plaque de circuit imprimé par l'intermédiaire d'éléments de connexion électrique.

Des dispositifs électroniques pourvus d'organes de dissipation de la chaleur vont maintenant être décrits à titre d'exemples non limitatifs, illustrés par le dessin dans lequel :
- la figure 1 représente une coupe d'un dispositif électronique ;
- la figure 2 représente une vue de dessus du dispositif électronique de la figure 1 ;
- la figure 3 représente une coupe d'un autre dispositif électronique ;
- la figure 4 représente, à titre illustratif, une coupe d'un autre dispositif électronique ; et
- la figure 5 représente une vue de dessus, en développé, d'un organe de dissipation de la chaleur du dispositif électronique de la figure 4.

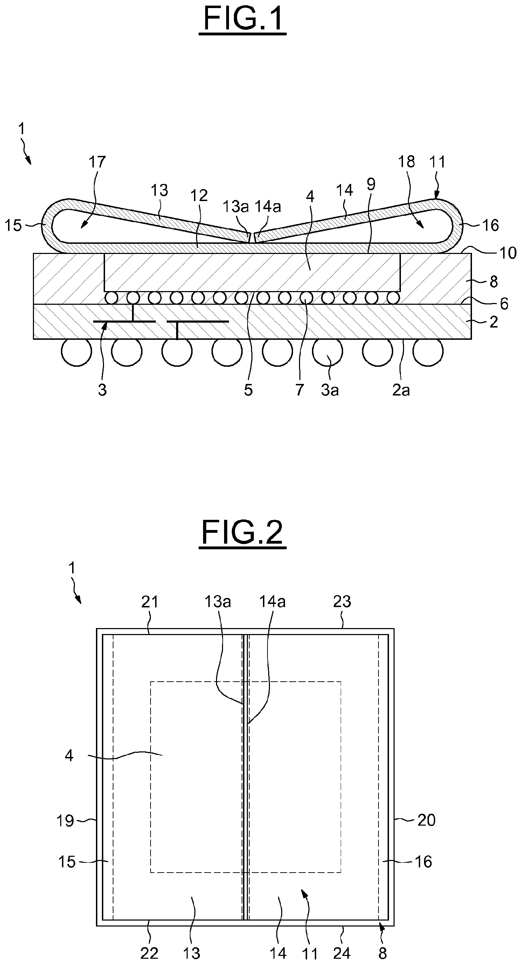

Un dispositif électronique 1, illustré sur les figures 1 et 2, comprend une plaquette de support 2 pourvue d'un réseau intégré de connexion électrique 3, un composant susceptible de produire de la chaleur tel qu'une puce de circuits intégrés 4 ou tout composant passif, présentant une face arrière 5 montée au-dessus d'une face avant 6 de la plaquette de support 2 par l'intermédiaire d'une pluralité d'éléments de connexion électrique 7, ces derniers reliant électriquement la puce 4 au réseau de connexion électrique 3.

Le dispositif électronique 1 comprend en outre un bloc d'encapsulation 8, par exemple en une résine époxy, formé sur la face avant 6 de la plaquette de support 2 et entourant la puce 4.

La face avant 10 du bloc d'encapsulation 8 est dans le prolongement de la face avant 9 de la puce 4.

Les flancs périphériques du bloc d'encapsulation 8 sont perpendiculaires à la plaque de support 2 et dans le prolongement des bords périphériques de cette dernière.

Par exemple, le dispositif électronique 1 se présente sous la forme d'un parallélépipède à contour carré.

La plaque de support 2 est munie, sur sa face arrière 2a, d'une pluralité d'éléments de connexion électrique extérieure 3a reliés au réseau de connexion électrique 3, par exemple en vue d'un montage sur un circuit imprimé par l'intermédiaire de ces éléments de connexion électrique 3a, pour constituer un système et/ou d'être intégré dans un système tel qu'un téléphone portable ou une tablette électronique.

Le dispositif électronique 1 est équipé d'un organe de dissipation de la chaleur, qui se présente sous la forme d'une feuille pliée 11 en une matière flexible conductrice de la chaleur.

Cette feuille flexible 11 comprend une pluralité de portions reliées par des plis et comprend, à titre de partie principale, une portion principale 12 qui s'étend au-dessus de la face avant 9 de la puce 4 et de la face avant 10 du bloc d'encapsulation 8. La portion principale 12 est fixée à plat sur ces faces avant 9 et 10. Par exemple, la partie principale 12 est carrée.

La feuille flexible 11 comprend en outre, à titre de partie secondaire, deux portions secondaires opposées 13 et 14 rabattues au-dessus de la portion principale 12 en formant des plis 15 et 16, situés de part et d'autre de la portion principale 12 et parallèles.

Les portions secondaires 13 et 14, substantiellement plates et rectangulaires, s'étendent approximativement chacune sur la moitié de la portion principale 12 de sorte que leurs extrémités 13a et 14a sont adjacentes et parallèles aux plis 15 et 16 et sont fixées sur la portion principale 12. Les plis 15 et 16 ne sont pas écrasés et sont arrondis, de sorte que, à l'exception de leurs extrémités adjacentes 13a et 14a qui lui sont adjacentes ou accolées, les portions secondaires 13 et 14 sont en vis-à-vis et à distance de la portion principale 12 en laissant des espaces d'écartement 17 et 18.

La feuille flexible 11 ne dépasse pas par rapport à la périphérie du bloc d'encapsulation 8. Par exemple, les plis 15 et 16 de la feuille 11 sont parallèles aux deux flancs opposés 19 et 20 du bloc d'encapsulation 8 et sont vers l'intérieur par rapport à ces flancs 19 et 20. Les bords latéraux d'extrémité 21 et 22 de la feuille 11, qui sont perpendiculaires aux plis 15 et 16, sont parallèles aux deux autres flancs opposés 23 et 24 du bloc d'encapsulation 8 et sont vers l'intérieur par rapport à ces flancs 23 et 24.

Selon un mode de confection, on dispose d'une feuille flexible 11 rectangulaire à l'état plat. A l'aide d'une machine, on rabat des portions d'extrémité 13 et 14 sur une portion principale centrale 12 pour l'obtention de la feuille 11 et on fixe des extrémités 13a et 14a sur la portion principale 12. Puis, à l'aide d'une machine, on place et on fixe la portion principale 12 de la feuille 11 préfabriquée obtenue sur la puce 4 et le bloc d'encapsulation dans la position désirée.

Selon un autre mode de confection, on dispose d'une feuille flexible 11 rectangulaire plate. A l'aide d'une machine, on place et on colle la portion centrale principale 12 de cette feuille 11 sur la puce 4 et le bloc d'encapsulation 8 dans la position désirée. Puis, à l'aide d'une machine, on rabat les portions secondaires d'extrémité 13 et 14 sur la portion centrale principale 12 et on fixe les extrémités 13a et 14a sur la portion principale 12.

Selon une variante de réalisation, la feuille flexible 1 pourrait comprendre, à titre de partie secondaire, quatre portions secondaires triangulaires rabattues sur la portion principale 12 en formant quatre plis deux à deux opposés depuis les côtés opposés de la portion principale 12. Les pointes des quatre portions secondaires triangulaires, qui sont adjacentes dans la zone du milieu de la portion principale 12 sont collées sur cette dernière. Les côtés adjacents de ces portions secondaires triangulaires sont, de préférence, distantes les unes des autres afin qu'il existe des fentes entre ces côtés.

La feuille flexible pliée 11 a l'avantage de présenter, pour l'évacuation de la chaleur produite par la puce 4, d'une part une grande surface d'échanges thermiques avec le bloc d'encapsulation 8 constituée par la zone périphérique de la face arrière de la portion principale 12 et d'autre part une grande surface d'échanges thermiques avec l'extérieur constituée par la face avant de la portion principale 12 et les deux faces opposées des portions secondaires 13 et 14 et des plis 15 et 16. En outre, l'épaisseur du dispositif électronique 1 n'est constituée substantiellement que de l'addition des épaisseurs de la plaquette de support 2, de la puce 4 et des plis 15 ou 16, de sorte que l'encombrement du dispositif électronique 1 reste réduit. De plus, grâce à la fixation de la portion 12 sur la puce 4 et la fixation locale des extrémités locales 13a et 14a des deuxièmes portions 13 et 14 sur la première portion 12, en des endroits espacés, la feuille flexible pliée 11 garde sa forme et est correctement maintenue par rapport à la puce 4 et au support 2.

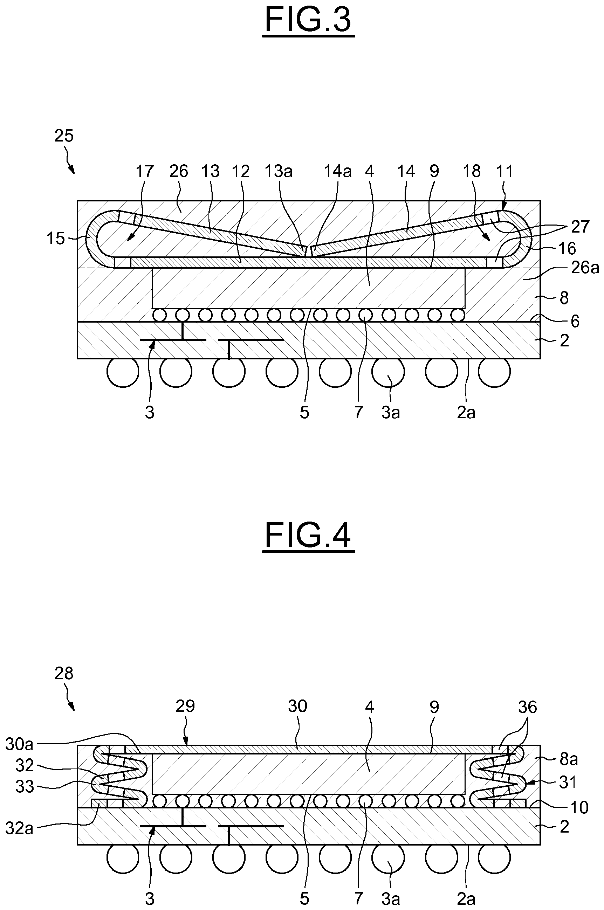

Selon une variante de réalisation illustrée sur la figure 3, un dispositif électronique 25 comprend le dispositif électronique 1 et comprend en outre un bloc complémentaire d'encapsulation 26 qui est formé au-dessus de la face avant 10 du bloc d'encapsulation 8 et dans lequel la feuille flexible 11 est noyée, le bloc d'encapsulation 8 et le bloc complémentaire d'encapsulation 26 formant un bloc commun d'encapsulation 26a de la puce 4 et de la feuille flexible 11. Le dispositif électronique 25 pourvu du bloc d'encapsulation 8 et du bloc complémentaire d'encapsulation 26 est de forme parallélépipédique. Grâce à sa fixation en des endroits espacés comme indiqué plus haut, la feuille flexible 11 garde sa forme et est correctement maintenue avant et lors de l'opération de réalisation du bloc complémentaire d'encapsulation 26 dans un moule.

Afin de faciliter l'écoulement de la matière d'encapsulation lors de la formation du bloc d'encapsulation 26, il est avantageux que la feuille flexible 11 présente une pluralité de perforations 27 judicieusement placées.

Là également, la feuille flexible pliée 11 a l'avantage de présenter, pour l'évacuation de la chaleur produite par la puce 4, une grande surface d'échanges thermiques avec le bloc d'encapsulation 26a, les échanges thermiques avec l'extérieur se produisant via les surfaces extérieures du bloc d'encapsulation 26a et principalement via la face avant du bloc complémentaire d'encapsulation 26.

Selon une variante de réalisation illustrée sur la figure 4, à titre illustratif, un dispositif électronique 28 se différencie du dispositif électronique 1 décrit en référence à la figure 1 par le fait qu'il comprend un dissipateur de chaleur formé par une feuille flexible 29 en une matière conductrice de la chaleur, dont la forme et la disposition sont différentes de celles de la feuille flexible 11.

Cette feuille flexible 29 comprend une pluralité de portions successives reliées par des plis et comprend, à titre de partie principale, une portion principale 30 qui s'étend au-dessus de la face avant 9 de la puce 4 et de la face avant 10 du bloc d'encapsulation 8. La portion principale 30, qui est carrée, est fixée à plat sur ces faces avant 9 et 10.

La feuille flexible 29 comprend en outre, à titre de partie secondaire, quatre rubans 31 qui s'étendent depuis respectivement les quatre côtés de la portion principale 30 et latéralement et à distance des flancs de la puce 4, ces rubans 31 étant noyés dans un bloc d'encapsulation 8a.

Les rubans 31 comprennent respectivement une pluralité de portions secondaires 32 qui sont rabattues en accordéon, successivement les unes par rapport aux autres et par rapport à la portion principale 30, en formant des plis 33. Ces plis 33 sont, respectivement, parallèles aux côtés correspondants de la portion principale 30.

Les portions secondaires 32 s'étendent en vis-à-vis les unes des autres et forment successivement et alternativement des V entre elles et avec les zones terminales de la face arrière de la partie principale 30.

Les portions terminales 32a des rubans 31, les plus éloignées de la portion principale 30, présentent des zones locales collées sur la face avant de la plaquette de support 2. Avantageusement, les portions terminales 32a des rubans 31 peuvent être fixées à plat sur la plaquette de support 2.

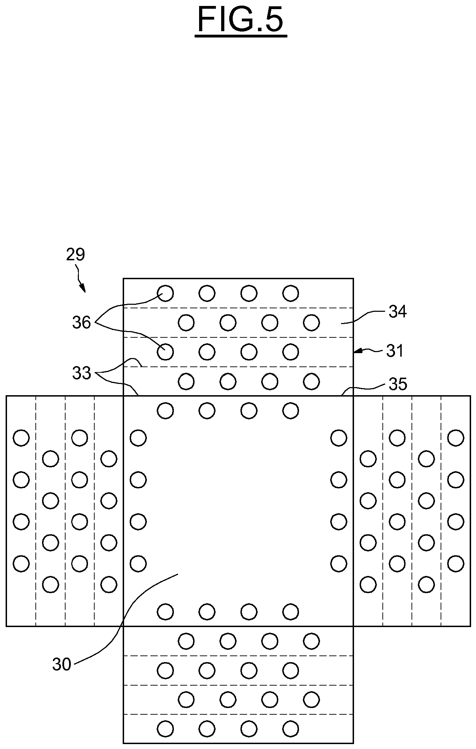

Selon un mode de confection, on dispose, comme illustré sur la figure 5, d'une feuille flexible plate 30 qui comprend une portion centrale 30 et des pans rectangulaires 34 prolongeant les côtés 35 de cette portion centrale 30.

A l'aide d'une machine, on plie les pans 34 de manière à confectionner les rubans 31.

Ensuite, on place la feuille flexible 30 confectionnée à cheval sur la puce 4 et, en même temps, on fixe la face arrière de la portion principale 30 sur la face avant 9 de la puce 4 et les portions terminales 32a des rubans 31 sur la face avant 10 de la plaquette de support 2.

Ensuite, on forme le bloc d'encapsulation 8a autour de la puce 4, en noyant les rubans 31. Pour faciliter la réalisation de ce bloc d'encapsulation les rubans 31 peuvent présenter une pluralité de perforations 36 judicieusement placées.

La feuille flexible pliée 29 a l'avantage de présenter, pour l'évacuation de la chaleur produite par la puce 4, d'une part une grande surface d'échanges thermiques avec l'extérieur constituée par la face avant de la portion principale 30 et d'autre part une grande surface d'échanges thermiques avec le bloc d'encapsulation 8a constituée par les faces des rubans 31, les échanges thermiques avec l'extérieur se produisant via les surfaces extérieures du bloc d'encapsulation 8a. En outre, des échanges thermiques avec la plaquette de support 2 se produisent via les portions terminales 32a des rubans 31. De plus, de façon équivalente à ce qui a été indiqué plus haut à propos de la feuille flexible 11, en étant fixée en des endroits espacés formées par la portion 30, qui constitue une première portion, et les portions 32a, qui constituent des deuxièmes portions, la feuille flexible 29 est maintenue avant et lors de l'opération de réalisation du bloc d'encapsulation 8a dans un moule.

Les feuilles flexibles 11 et 29 des exemples de réalisation décrits peuvent être en cuivre ou en graphite.

La fixation des parties principales 12 et 30 des feuilles flexibles 11 et 29 sur la puce 4 peut être assurée grâce à une couche fine de colle thermique ou de pâte thermique ou par soudage ou par adhésion moléculaire par compression.

Les extrémités 13a et 14a sont fixées sur la portion principale 12 de la feuille flexible 11 par l'intermédiaire d'une colle thermique ou d'une pâte thermique ou par soudage ou par adhésion moléculaire par compression.

Les portions terminales 32a de la feuille flexible 29 peuvent être fixées sur la plaquette de support 2 par l'intermédiaire d'une colle thermique ou d'une pâte thermique ou par soudage ou par adhésion moléculaire par compression.

Le dispositif électronique peut résulter d'une fabrication collective dans laquelle une plaque commune comprend, dans des emplacements, des réseaux de connexion électrique intégrés, dans laquelle les puces et les feuilles flexibles associées sont placées par report et dans laquelle un bloc commun d'encapsulation est réalisé. Ensuite, il est procédé à une découpe, par exemple par sciage pour singulariser les dispositifs formés dans chaque emplacement.

## Revendications

1. Dispositif électronique comprenant un support (2), un composant, en particulier une puce de circuits intégrés (4), présentant une face arrière montée au-dessus d'une face avant du support et une face avant opposée à sa face arrière, et un bloc d'encapsulation (8, 26a) au moins partiel du composant au-dessus de la face avant du support, dispositif comprenant en outre au moins un organe de dissipation de la chaleur comprenant une feuille flexible (11) présentant une pluralité de portions successives, dans laquelle au moins deux portions (12, 13 ; 32) sont jointes par un pli et sont au moins en partie en vis-à-vis l'une de l'autre, une première portion (12) de ladite feuille flexible étant fixée au moins localement sur la face avant dudit composant, **caractérisé par le fait que** l'extrémité d'une deuxième portion (13) de ladite feuille flexible est fixée au moins localement sur la première portion par l'intermédiaire d'une colle thermique ou d'une pâte thermique ou par soudage ou par adhésion moléculaire par compression.

2. Dispositif selon la revendication 1, dans lequel ladite feuille flexible comprend au moins une partie principale (12) comprenant au moins ladite première portion et au moins une partie secondaire (13) comprenant au moins ladite deuxième portions.

3. Dispositif selon la revendication 2, dans lequel ladite partie secondaire comprend au moins une portion rabattue au-dessus de ladite partie principale.

4. Dispositif selon l'une quelconque des revendications précédentes, dans lequel la feuille flexible est au moins en partie noyée dans le bloc d'encapsulation.

5. Dispositif selon l'une quelconque des revendications précédentes, dans lequel ladite feuille flexible présente des perforations.

6. Dispositif selon l'une quelconque des revendications précédentes, dans lequel ladite feuille flexible est en cuivre ou en graphite.

## Patentansprüche

1. Elektronische Vorrichtung mit einem Träger (2), einem Bauteil, insbesondere einem integrierten Schaltkreischip (4), der eine über einer Vorderseite des Trägers angebrachte Rückseite und eine seiner Rückseite gegenüberliegende Vorderseite aufweist, und einem Verkapselungsblock (8, 26a), der das Bauteil mindestens teilweise über der Vorderseite des Trägers einkapselt, wobei die Vorrichtung außerdem mindestens ein Wärmeableitungsorgan umfasst, das eine biegsame Folie (11) mit mehreren aufeinanderfolgenden Abschnitten umfasst, von denen mindestens zwei Abschnitte (12, 13; 32) durch eine Faltung miteinander verbunden sind und sich mindestens teilweise gegenüberliegen, wobei ein erster Abschnitt (12) der biegsamen Folie mindestens lokal an der Vorderseite des Bauteils befestigt ist, **dadurch gekennzeichnet**, **dadurch gekennzeichnet, dass** das Ende eines zweiten Abschnitts (13) der flexiblen Folie zumindest lokal an dem ersten Abschnitt mittels eines thermischen Klebstoffs oder einer thermischen Paste oder durch Schweißen oder durch Molekularkompressionsbindung befestigt ist.

2. Vorrichtung nach Anspruch 1, wobei die flexible Folie mindestens ein Hauptteil (12) mit mindestens dem ersten Abschnitt und mindestens ein Nebenteil (13) mit mindestens dem zweiten Abschnitt umfasst.

3. Vorrichtung nach Anspruch 2, wobei der Nebenteil mindestens einen über den Hauptteil gefalteten Abschnitt umfasst.

4. Vorrichtung nach einem der vorhergehenden Ansprüche, wobei die flexible Folie mindestens teilweise in den Verkapselungsblock eingelassen ist.

5. Vorrichtung nach einem der vorhergehenden Ansprüche, wobei die flexible Folie Perforierungen aufweist.

6. Vorrichtung nach einem der vorhergehenden Ansprüche, wobei die flexible Folie aus Kupfer oder Graphit besteht.

## Claims

1. Electronical device comprising a support (2), a component, in particular an integrated circuit chip (4), having a rear face mounted above a front face of the support and a front face opposite the rear face thereof, and an at least partial encapsulation unit (8, 26a) of the component above the front face of the support, device further comprising a flexible sheet (11) having a plurality of successive portions, wherein at least portions (12, 13; 32) are joined by a fold and are at least partially opposite one another, a first portion (12) of said flexible sheet being fixed at least locally on the front face of said component, **characterised by** the fact that the end of a second portion (13) of said flexible sheet is fixed at least locally on the first portion by way of a thermal glue or a thermal paste or by welding or by molecular adhesion by compression.

2. Device according to claim 1, wherein said flexible sheet comprises at least one main portion (12) comprising at least said first portion and at least one secondary portion (13) comprising at least said second portion.

3. Device according to claim 2, wherein said secondary portion comprises at least one portion folded above said main portion.

4. Device according to any one of the preceding claims, wherein the flexible sheet is at least partially buried in the encapsulation unit.

5. Device according to any one of the preceding claims, wherein said flexible sheet has perforations.

6. Device according to any one of the preceding claims, wherein said flexible sheet is made of copper or made of graphite.
